# EUROPÄISCHE PATENTSCHRIFT

(11) **EP 3 413 487 B1**
(45) Veröffentlichungstag und Bekanntmachung des Hinweises auf die Patenterteilung: **25.09.2019**
(21) Anmeldenummer: 17174752.0
(22) Anmeldetag: 07.06.2017
(51) Int. Cl.: H04L 1/00, G06F 7/58, G06F 17/18, G06N 7/00, H03M 13/37, H03M 13/09, G05B 13/02, G06N 99/00

(54) **KANAL-ADAPTIVE FEHLERERKENNENDE CODES MIT GARANTIERTER RESTFEHLERWAHRSCHEINLICHKEIT**
CHANNEL-ADAPTIVE ERROR-DETECTING CODES WITH GUARANTEED RESIDUAL ERROR PROBABILITY
CODES DE DETECTION D'ERREUR ADAPTATIFS AU CANAL AYANT UNE PROBABILITÉ D'ERREUR RÉSIDUELLE GARANTIE

(43) Veröffentlichungstag der Anmeldung: 12.12.2018
(73) Patentinhaber: Siemens Aktiengesellschaft, 80333 München (DE)
(72) Erfinder: Mauerer, Bastian, 90427 Nürnberg (DE); Walter, Maximilian, 90408 Nürnberg (DE)

(56) Entgegenhaltungen:
- KUZNETSOV A ET AL: "On the Undetected Error Probability of Linear Block Codes on Channels with Memory", IEEE TRANSACTIONS ON INFORMATION THEORY, IEEE PRESS, USA, Bd. 42, Nr. 1, 1. Januar 1996 (1996-01-01) , XP011026463, ISSN: 0018-9448
- SCHILLER F ET AL: "Analysis of nested CRC with additional net data by means of stochastic automata for safety-critical communication", FACTORY COMMUNICATION SYSTEMS, 2008. WFCS 2008. IEEE INTERNATIONAL WORKSHOP ON, IEEE, PISCATAWAY, NJ, USA, 21. Mai 2008 (2008-05-21), Seiten 295-304, XP031344895, ISBN: 978-1-4244-2349-1
- UNRUH J ET AL: "ERROR DETECTION ANALYSIS OF AUTOMOTIVE COMMUNICATION PROTOCOLS", SAE SPECIAL PUBLICATIONS, SAE INC, US, 1. Januar 1990 (1990-01-01), Seiten 43-52, XP001007280, ISSN: 0099-5908
- MERCHANT K: "CRC-TEST EINMAL GANZ ANDERS BETRACHTET EINE METHODIK, PRIMAER AUSGERICHTET AUF SICHERHEITSRELEVANTE SYSTEME", ELEKTRONIK, W E K A FACHZEITSCHRIFTEN-VERLAG GMBH, DE, Bd. 52, Nr. 23, 11. November 2003 (2003-11-11), Seiten 86-92, XP001177410, ISSN: 0013-5658

## Beschreibung

Die vorliegende Erfindung betrifft ein Verfahren zur Überprüfung einer Signalübertragung einer vorgegebenen Nachricht mit einer Anzahl von d Bits von einem Sender zu einem Empfänger durch eine Steuereinheit unter Verwendung eines linearen Blockcodes, der mittels eines Codier-Werkzeugs realisiert wird, eines Kanalmodells und eines linearen Schieberegisters mit Rückkopplungen.

Bei der Übertragung von Nachrichten beziehungsweise Daten über einen Kanal von einem Sender zu einem Empfänger können bei der Signalübertragung Fehler auftreten. Um eine empfangene Nachricht auf Korrektheit zu überprüfen, werden häufig fehlererkennende Codes eingesetzt. Solche fehlererkennende Codes basieren beispielsweise auf dem bekannten CRC-Verfahren. Das CRC-Verfahren ist eine zyklische Redundanzprüfung zur Bestimmung eines Prüfwerts der übertragenen Nachricht. Die Berechnung dieses Prüfwerts beruht auf einer Polynomdivision. Dieses CRC-Polynom, auch häufig Generatorpolynom genannt, kann in verschiedenen Ausführungen auftreten. Das CRC-Verfahren ist für die Erkennung von zufälligen Fehlern ausgelegt. Es ist nicht geeignet, Fehler zu korrigieren.

Sind mehrere Bits der Nachricht und/oder der Prüfsumme zugleich verfälscht, kann es in seltenen Fällen dazu kommen, dass das CRC-Verfahren im Empfänger diese Fehlerkombination nicht erkennt und die Nachricht irrtümlicherweise als korrekt entgegengenommen wird. Fehlererkennende Codes sind niemals perfekt und eine absolute fehlerfreie Signalübertragung kann nicht garantiert werden. Für jeden Code lassen sich Fehlermuster generieren, die nicht erkannt werden können. Die Wahrscheinlichkeit, dass ein Fehler auftritt und nicht erkannt wird, wird als Restfehlerwahrscheinlichkeit bezeichnet. Vorzugsweise sollten Codes derart konstruiert sein, dass die Restfehlerwahrscheinlichkeit möglichst gering ist.

Die Restfehlerwahrscheinlichkeit hängt von mehreren Größen ab. Ein wichtiger Einflussfaktor sind die Eigenschaften des Kanals zur Signalübertragung. Hier ist vor allem die Häufigkeit und Verteilung von Bitfehlern ein wichtiger Einflussfaktor auf die Restfehlerwahrscheinlichkeit. Die Nachrichtenlänge sowie die Anzahl redundanter Bits beeinflussen ebenfalls die Restfehlerwahrscheinlichkeit. Mit dem Begriff "redundante Bits" wird in dieser vorliegenden Erfindung vornehmlich eine Prüfsumme verstanden. Die Art und Weise der Berechnung der redundanten Bits beeinflusst ebenfalls die Restfehlerwahrscheinlichkeit. Bei CRC-Verfahren wird diese Prüfsumme mittels eines Generatorpolynoms berechnet. Daher beeinflusst auch die Wahl des Generatorpolynoms die Restfehlerwahrscheinlichkeit.

Bisher wird das Generatorpolynom anhand von deterministischen Kriterien ausgewählt. Diese Kriterien sind beispielsweise ein minimaler Hamming-Abstand, eine maximale Länge von Fehlerbündeln, welche sicher erkannt werden können, usw. Diese Kriterien können bei einem gegebenen Code vergleichsweise einfach ermittelt werden und dienen als Anhaltspunkt für eine geringe Restfehlerwahrscheinlichkeit. So wird beispielsweise angenommen, dass ein großer Hamming-Abstand zu einer niedrigeren Restfehlerwahrscheinlichkeit führt. Diese Kriterien sind jedoch lediglich qualitative Anhaltspunkte und es können Gegenbeispiele konstruiert werden, bei denen diese qualitativen Kriterien eine falsche Restfehlerwahrscheinlichkeit vortäuschen.

So können beispielsweise beim CRC-Verfahren Bitfehler in der zu übertragenen Nachricht und weitere Bitfehler bei den redundanten Bits, also in der Prüfsumme, dazu führen, dass bei der Anwendung des CRC-Verfahrens ein korrekter Prüfwert erscheint. In diesem Fall würden sich diese Fehler gegenseitig kompensieren. Das CRC-Verfahren würde als Ergebnis vermelden, dass die Nachricht korrekt übertragen wurde, obwohl mehrere Bitfehler aufgetreten sind. Entsprechend können bei anderen Verfahren ebenfalls spezielle Gegenbeispiele konstruiert werden, bei denen die bisher eingesetzten Kriterien mit einer gewissen Wahrscheinlichkeit eine falsch übertragene Nachricht nicht erkennen.

Daher basieren moderne Verfahren auf der direkten Berechnung der Restfehlerwahrscheinlichkeit. Die Restfehlerwahrscheinlichkeit quantifiziert somit jenen Fall, wenn eine Nachricht falsch übertragen wurde und dies zugleich bei der Überprüfung fälschlicherweise nicht festgestellt wurde. Für die Berechnung der Restfehlerwahrscheinlichkeit muss ein geeignetes Kanalmodell definiert werden, dass die Häufigkeit und Verteilung der Bitfehler beschreibt.

Bisher wird im Stand der Technik lediglich ein einfaches Kanalmodell, das sogenannte binäre symmetrische Kanalmodell (BSC-Modell), verwendet. Dieses Modell geht von einer konstanten Bitfehlerwahrscheinlichkeit aus und nimmt an, dass die Bitfehler unabhängig voneinander auftreten. Diese Annahmen sind jedoch relativ realitätsfremd. So können sich die Bitfehlerwahrscheinlichkeiten ändern, wenn beispielsweise ein System in verschiedenen Umgebungen zum Einsatz kommt. Zum Beispiel werden bei einem Datenkabel vermehrt Bitfehler bei der Signalübertragung auftreten, wenn in der Nähe sich eine starke Wärmequelle befindet. Dies könnte zum Beispiel ein Schweißvorgang sein. In diesem Fall würde auch die Wahrscheinlichkeit von Fehlerbündeln zunehmen. Das heißt die beim BSC-Modell getroffene Annahme von unabhängigen Bitfehlern würde bei dem Beispiel mit dem Schweißvorgang nicht mehr gelten.

Somit ist insgesamt festzustellen, dass das BSC-Modell den Anforderungen der Praxis meistens nur unzureichend genügt. Zwar kann das binäre symmetrische Kanalmodell (BSC-Modell) für eine Abschätzung der Restfehlerwahrscheinlichkeit verwendet werden, jedoch bleibt diese Abschätzung aufgrund der vorgenannten Mängel häufig sehr konservativ.

Da bisher zur Berechnung der Restfehlerwahrscheinlichkeit lediglich das binäre symmetrische Kanalmodell zum Einsatz kommt, kann davon ausgegangen werden, dass bei der Berechnung der Restfehlerwahrscheinlichkeit noch erhebliches Potenzial für Verbesserungen bei deren genaueren Berechnung vorhanden ist.

Kuznetsov u.a. "On the Undetected Error Probability of Linear Block Codes on Channels with Memory", IEEE Trans. Inf. Theory, vol. 42, no. 1, Jan. 1996, offenbart eine rekursive Kalkulation der Wahrscheinlichkeit der unerkannten Fehler im Fall eines linearen Blockcodes, der als fehlererkennender Code benutzt wird. Die rekursive Kalkulation basiert sich auf einer Trellis-Darstellung des Blockcodes.

Die Aufgabe der vorliegenden Erfindung besteht darin, bei einem fehlererkennenden Code die Restfehlerwahrscheinlichkeit exakter zu bestimmen.

Diese Aufgabe wird durch die vorliegende Erfindung gemäß Patentanspruch 1 und 11 gelöst. Weiterbildungen der vorliegenden Erfindung ergeben sich aus den Unteransprüchen.

Die vorliegende Erfindung sieht ein Verfahren zur Überprüfung einer Signalübertragung einer vorgegebenen Nachricht mit einer Anzahl von d Bits von einem Sender zu einem Empfänger durch eine Steuereinheit unter Verwendung eines linearen Blockcodes, der mittels eines Codier-Werkzeugs realisiert wird, eines Kanalmodells und eines lineares Schieberegisters mit Rückkopplungen mit den folgenden Schritten vor. Das Codier-Werkzeug kann dabei als lineares Schieberegister mit Rückkopplungen ausgebildet sein oder als Software realisiert sein. Ein linearer Blockcode wird zum Beispiel durch ein lineares Schieberegister mit Rückkopplungen implementiert. Die Verwendung von linearen Schieberegistern mit Rückkopplungen ist bei der Generierung von linearen Blockcodes häufig anzutreffen. Zunächst wird das Kanalmodell durch einen charakterisierenden Markov-modulierten Bernoulliprozess beschrieben.

Ein Markov-modulierter Bernoulliprozess kann beispielsweise als Zustandsdiagramm mit Zahlenwerten dargestellt werden, in dem die verschiedenen Zustände, die jeweiligen Übergangswahrscheinlichkeiten und die jeweiligen Bitfehlerwahrscheinlichkeiten eingetragen sind. Es ist jedoch auch eine tabellarische Darstellung zum Beispiel unter Verwendung einer Übergangsmatrix für die Übergangswahrscheinlichkeiten möglich. Ein Markov-modulierter Bernoulliprozess weist eine endliche Menge mit N Zuständen auf. Jedem Zustand i ist eine dazugehörige Bitfehlerwahrscheinlichkeit pi zugeordnet. Mithilfe einer stochastischen NxN Matrix können Übergangswahrscheinlichkeiten angegeben werden, welche die Wahrscheinlichkeit angeben, dass eine Zustandsänderung von einem Zustand in einen anderen oder gleichen Zustand erfolgt. Die Darstellung dieses Markov-modulierten Bernoulliprozesses ist dabei als Zustandsdiagramm in der Regel übersichtlicher.

Anschließend findet ein erstes iteratives Berechnen von Wahrscheinlichkeitswerten für eine Wahrscheinlichkeitsverteilung von Zuständen eines bezogen auf ein aktuelles Bit der d Bits nach der Signalübertragung durch eine Signalübertragungseinheit ausgehend von der aktuellen Wahrscheinlichkeitsverteilung der Zustände des aktuellen Bits unter Berücksichtigung aller möglichen Übergänge, welche sich aus dem kartesischen Produkt der Anzahl der Zustände gemäß dem vorgegebenen Markov-modulierten Bernoulliprozess und der Anzahl der Zustände des linearen Schieberegisters mit Rückkopplungen ergeben, wobei die Steuereinheit die Wahrscheinlichkeitswerte von Übergängen in einen gleichen Zustand addiert und diese Iteration bis zur Wahrscheinlichkeitsverteilung des letzten Bits ausführt. Im weiteren Verlauf dieses Verfahrens findet ein iteratives zweites Berechnen von Wahrscheinlichkeitswerten für die Wahrscheinlichkeitsverteilung der Zustände eines bezogen auf ein aktuelles Bit der d Bits nach der Signalübertragung durch die Signalübertragungseinheit ausgehend von der aktuellen Verteilung der Zustände des aktuellen Bits unter Vernachlässigung aller Übergänge aus einem vorgegebenen Nullzustand heraus statt, wobei die Steuereinheit die Wahrscheinlichkeitswerte von Übergängen in einen gleichen Zustand addiert und diese Iteration bis zur Wahrscheinlichkeitsverteilung des letzten Bits ausführt.

Danach wird eine Differenz von den Wahrscheinlichkeitswerten des vorgegebenen Nullzustands aus der ersten iterativen Berechnung mit den Wahrscheinlichkeitswerten des vorgegebenen Nullzustands aus der zweiten iterativen Berechnung gebildet, wobei diese Differenz die Restfehlerwahrscheinlichkeit darstellt.

Diese Verfahrensschritte ermöglichen es, verschiedene Kanalmodelle bei der Berechnung der Restfehlerwahrscheinlichkeit einzusetzen. Kanalmodelle sind geeignet, den Prozess der Signalübertragung zu beschreiben. Sie werden oft durch ein Zustandsdiagramm veranschaulicht. Darin sind meist Angaben zu den Bitfehlerwahrscheinlichkeiten sowie zu den Übergangswahrscheinlichkeiten zu finden. So ist es beispielsweise nicht länger nötig, dass die Bitfehlerwahrscheinlichkeit konstant ist, wie es bei dem binärsymmetrischen Kanalmodell (BSC-Modell) der Fall ist. Auch unterschiedliche Übergangswahrscheinlichkeiten können bei der Berechnung der Restfehlerwahrscheinlichkeit berücksichtigt werden. Durch eine entsprechende Anpassung des Markov-modulierten Bernoulliprozesses beziehungsweise des vorgegebenen Nullzustands kann die Berechnung der Restfehlerwahrscheinlichkeit flexibel angepasst auf ein realistischeres Kanalmodell erfolgen.

Eine sinnvolle alternative Ausgestaltungsform der vorliegenden Erfindung sieht dabei vor, dass die iterative zweite Berechnung der Wahrscheinlichkeitswerte für die Wahrscheinlichkeitsverteilung der Zustände des letzten Bits unter Vernachlässigung aller Übergänge aus dem vorgegebenen Nullzustand heraus zusammen mit der ersten iterativen Berechnung erfolgt unter Verwendung lokaler Speicherstellen, die die Ergebnisse der iterativen Berechnung zumindest bis zur Berechnung der Restfehlerwahrscheinlichkeit zwischenspeichern. Dieses alternative Verfahren führt zu dem gleichen Ergebnis wie das Verfahren gemäß Hauptanspruch 1. Die iterative Berechnung wird in diesem Beispiel nicht zweimal ausgeführt, sondern es werden lokale Speicherstellen angelegt, in denen die Wahrscheinlichkeitswerte des vorgegebenen Nullzustands des aktuellen Bits gespeichert werden, wobei in diesem Fall alle Übergänge aus dem vorgegebenen Nullzustand heraus vernachlässigt werden. Die iterative erste Berechnung wird jedoch wie zuvor beschrieben ausgeführt. Diese Ausführungsform der vorliegenden Erfindung erspart eine zweite separate iterative Berechnung durch die Steuereinheit. Dafür jedoch legt die Steuereinheit lokale Speicherstellen an und berechnet die Wahrscheinlichkeitswerte, die in den lokalen Speicherstellen zwischengespeichert werden, nur für jene Übergänge, die im Nullzustand beginnen und auch darin verbleiben. Durch den Einsatz dieser lokalen Speicherstellen anstelle der zweiten iterativen Berechnung können sich Vorteile hinsichtlich der Rechenzeit beziehungsweise Rechenleistung ergeben.

In einer vorteilhaften Variante der vorliegenden Erfindung wird das lineare Schieberegister mit Rückkopplungen, welches mittels eines Generatorpolynoms parametrisiert ist, als Codier-Werkzeug eingesetzt. Das lineare Schieberegister mit Rückkopplungen weist eine bestimmte Länge auf. Diese Länge beeinflusst das Generatorpolynom beziehungsweise umgekehrt. Ferner können Generatorpolynome mit unterschiedlichen Längen ebenfalls unterschiedlich sein. Durch unterschiedlich platzierte XOR-Schaltungen kann ein anderes Generatorpolynom realisiert werden. Zum Beispiel kann je nach Anordnung der XOR-Schaltungen bei einem linearen Schieberegister mit Rückkopplungen der Länge 3 das Polynom x^3+x^2 oder das Polynom x^3+x umgesetzt werden. Damit kann die Generierung des linearen Blockcodes beeinflusst werden und somit auch die Signalübertragung.

Eine weitere Ausführungsform der vorliegenden Erfindung sieht vor, dass zu Beginn des Verfahrens eine Tabelle mit d+1 Spalten generiert wird, welche mit Nullen allokiert wird, wobei in den Spalten die jeweiligen Wahrscheinlichkeitswerte eingetragen werden. In diesem Fall wird die Restfehlerwahrscheinlichkeit anhand einer Tabelle berechnet. Dabei ist es rechentechnisch günstig, wenn die Größe der Tabelle im Vorfeld bereits festgelegt wird. Dies erfolgt dadurch, dass die Tabelle mit Nullen allokiert wird. Anstatt von Nullen können jedoch auch andere Zahlenwerte oder auch Buchstaben zur Allokation verwendet werden.

Die Anzahl der Zeilen der Tabelle hängt nicht von der Länge der zu übertragenen Nachricht ab, sondern von einer Länge des linearen Schieberegisters mit Rückkopplungen sowie der Anzahl der Zustände des Markov-modulierten Bernoulliprozesses. Diese Ausgestaltungsform der Erfindung ist besonders dann vorteilhaft, wenn gewünscht ist, die Berechnung der Restfehlerwahrscheinlichkeit nachzuvollziehen. Im Rahmen von Lehrzwecken kann es sinnvoll sein, einen Teil der Tabelle sichtbar zu machen. Damit kann möglicherweise der Rechenvorgang besser nachvollzogen werden sowie etwaige Fehler besser erkannt werden. Dies ist mittels der Tabelle einfacher möglich, als wenn das Verfahren lediglich die Restfehlerwahrscheinlichkeit als Endergebnis ausgibt.

Eine vorteilhafte weitere Ausführungsform der vorliegenden Erfindung sieht vor, dass bei dem vorgegebenen Kanalmodell unterschiedliche Generatorpolynome zur Berechnung der Restfehlerwahrscheinlichkeit eingesetzt werden. Je nach Situation beziehungsweise Umgebungsparameter können unterschiedliche Generatorpolynome für die Signalübertragung infrage kommen. In diesem Fall ist es sehr vorteilhaft, für unterschiedliche Generatorpolynome die jeweilige Restfehlerwahrscheinlichkeit zu kennen. Auf der Grundlage der so berechneten Restfehlerwahrscheinlichkeiten kann eine sinnvolle Auswahl eines bedarfsgerechten Generatorpolynoms vorgenommen werden.

In einer weiteren Variante dieser Erfindung ist vorgesehen, dass für unterschiedliche Kanalmodelle mit jeweiligem Markov-modulierten Bernoulliprozess die jeweilige Restfehlerwahrscheinlichkeit berechnet wird. Wenn beispielsweise mehrere Kanäle vorliegen, wie zum Beispiel eine drahtlose Übertragung oder eine kabelgebundene Signalübertragung, so kann für jeden Kanal ein entsprechendes Kanalmodell vorgesehen sein. Bei dieser Variante kann für die unterschiedlichen Kanalmodelle eine zugehörige Restfehlerwahrscheinlichkeit ermittelt werden. Auf Grundlage dieser Berechnung kann ein optimaler Kanal für die Signalübertragung ausgewählt werden.

Eine weitere Variante der Erfindung sieht vor, dass die Steuereinheit zur Berechnung der Restfehlerwahrscheinlichkeit nur jeweils zwei Spalten der Tabelle gleichzeitig im Speicher hält. Ist eine Nachvollziehbarkeit der Berechnung der Restfehlerwahrscheinlichkeit erwünscht, so ist es sinnvoll, die komplette Tabelle abzuspeichern. Dies erfordert jedoch erhöhten Speicher- und Rechenbedarf. Da zur Berechnung des nächsten Zustands lediglich der aktuelle Zustand nötig ist, ist es möglich, lediglich zwei Spalten der Tabelle temporär abzuspeichern beziehungsweise im Speicher zu halten. So kann beispielsweise anhand einer zweiten Spalte eine dritte Spalte berechnet werden. Um eine vierte Spalte zu berechnen sind lediglich die Informationen aus der dritten Spalte notwendig. In diesem Beispiel kann nun die zweite Spalte wieder gelöscht werden.

Eine sinnvolle weitere Ausgestaltungsform der vorliegenden Erfindung sieht vor, dass das Generatorpolynom durch einen Regelkreis anhand der Restfehlerwahrscheinlichkeiten ausgewählt wird. Ändern sich beispielsweise während des Betriebs der Signalübertragung die äußeren Umstände, zum Beispiel durch eine erhöhte Temperatur, so kann dies zu einer Veränderung des Kanalmodells und damit der Restfehlerwahrscheinlichkeit führen. In diesem Fall kann ein Regelkreis vorsehen, dass für andere Generatorpolynome die Restfehlerwahrscheinlichkeit durch die Steuereinheit ermittelt wird und basierend auf verschiedenen Restfehlerwahrscheinlichkeiten ein anderes Generatorpolynom für die Signalübertragung ausgewählt wird. Damit ist es möglich, auf Veränderungen von äußeren Umständen, welche die Signalübertragung beeinflussen, flexibel zu reagieren. In dieser Ausführungsform der vorliegenden Erfindung ist die Berechnung der Restfehlerwahrscheinlichkeit nicht mehr statisch sondern kann dynamisiert werden.

In einer weiteren Variante der vorliegenden Erfindung ist vorgesehen, dass das Auswählen des jeweiligen Generatorpolynoms gelernt wird. Dabei erfolgt die Auswahl des jeweiligen Generatorpolynoms selbstständig und wird fortlaufend verbessert. Das heißt die Auswahl des jeweiligen Generatorpolynoms wird zunehmend intelligent ausgeführt. So kann das erfindungsgemäße Verfahren mit einem lernenden System, beispielsweise einer künstlichen Intelligenz, kombiniert werden. Dies ermöglicht es, dass ein jeweiliges Generatorpolynom durch die Steuereinheit selbstständig angepasst werden kann. Der im vorigen Absatz geschilderte Regelkreis ist in dieser Variante lernfähig. Er reagiert auf sich ändernde äußere Umstände und kann auf Erfahrungswerte aus der Vergangenheit zurückgreifen, um die Auswahl eines geeigneten Generatorpolynoms zu verbessern oder zu beschleunigen.

Eine weitere Ausführungsform der vorliegenden Erfindung sieht vor, dass zur Initialisierung des iterativen Berechnens eine stationäre Verteilung der Wahrscheinlichkeitswerte für den vorgegebenen Nullzustand festgelegt wird. Um die iterative Berechnung zu beginnen, wird eine Wahrscheinlichkeitsverteilung für die Berechnung des ersten Iterationsschritts vorgegeben. Diese Wahrscheinlichkeitsverteilung kann nicht aus lauter Nullen bestehen, da sonst keine von einer Null abweichenden Wahrscheinlichkeitsverteilung berechnet werden kann. Stattdessen wird eine stationäre Wahrscheinlichkeitsverteilung angenommen, welche sich ergibt, wenn der vorgegebene Markov-modulierte Bernoulliprozess lange genug, das heißt im mathematischen Sinne unendlich lang, eingesetzt wird. Die Berechnung dieser stationären Verteilung ist für das erfindungsgemäße Verfahren jedoch nicht von Bedeutung. Es ist lediglich nötig, diese stationäre Verteilung der Wahrscheinlichkeitswerte zur Initialisierung des iterativen Berechnens zu verwenden.

Die vorliegende Erfindung stellt auch eine Vorrichtung zur Überprüfung einer Signalübertragung einer vorgegebenen Nachricht mit d Bits von einem Sender zu einem Empfänger durch eine Steuereinheit bereit, die dazu ausgebildet ist das erfindungsgemäße Verfahren durchzuführen.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht in der jeweils angegebenen Kombination, sondern auch in anderen Kombinationen verwendbar, ohne den Rahmen der Erfindung zu verlassen.

Im Folgenden werden verschiedene Ausführungsbeispiele der vorliegenden Erfindung beschrieben. Diese werden nun anhand der beigefügten Zeichnungen näher erläutert, in denen zeigen:
- FIG 1: ein numerisches Beispiel einer Markovkette mit den Zuständen S0, S1 und S2 sowie den dazugehörigen Übergangswahrscheinlichkeiten und Bitfehlerwahrscheinlichkeiten zur Beschreibung des charakterisierenden Markov-modulierten Bernoulliprozesses,
- FIG 2: ein Flussdiagramm zur Darstellung der Verfahrensschritte zur Berechnung der Restfehlerwahrscheinlichkeit,
- FIG 3: eine beispielhafte Tabelle mit Übergängen aus dem vorgegebenen Nullzustand heraus, sowie
- FIG 4: eine beispielhafte Tabelle mit einem Übergang von einem fehlerhaften Zustand in den vorgegebenen Nullzustand zurück.

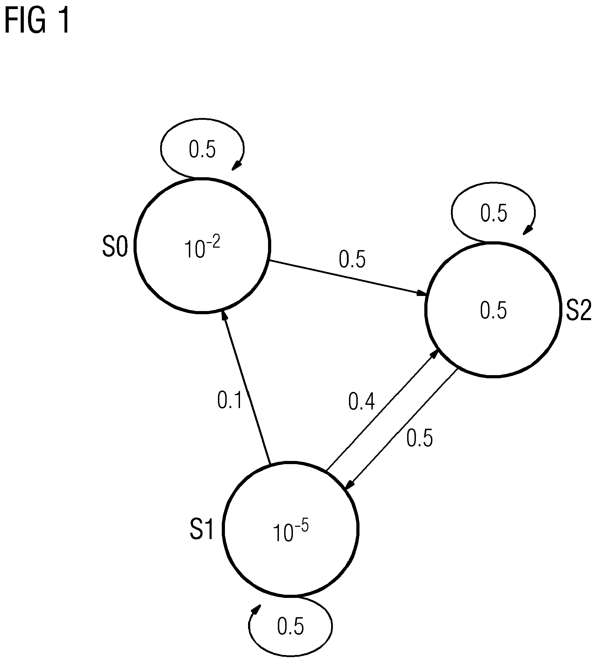

FIG 1 zeigt beispielhaft eine Markovkette mit den Zuständen S0, S1 und S2. Diese Zustände sind durch schwarze Kreise gekennzeichnet. Innerhalb dieser Zustände ist jeweils ein Zahlenwert eingetragen. Dieser Zahlenwert stellt die jeweilige Bitfehlerwahrscheinlichkeit im jeweiligen Zustand dar. So weist in diesem Fall der Zustand S1 eine relativ geringe Bitfehlerwahrscheinlichkeit in Höhe von p1=10^(-5) auf, während hingegen im Zustand S2 die Bitfehlerwahrscheinlichkeit p2=0,5 beträgt. Diese drei beispielhaften Zustände S0, S1 und S2 sind durch Übergangswahrscheinlichkeiten verknüpft. Die möglichen Übergänge der Zustände werden durch die jeweiligen Pfeile und deren Richtungen angedeutet. Die dazugehörige Zahl gibt die jeweilige Übergangswahrscheinlichkeit an. So weist der Zustand S1 drei Übergangswahrscheinlichkeiten auf. Mit einer Wahrscheinlichkeit von 0,1 ändert sich der Zustand S1 in den Zustand S0, mit einer Wahrscheinlichkeit von 0,4 wird ausgehend vom Zustand S1 der Zustand S2 eingenommen. Befindet man sich im Zustand S1 so beträgt die Wahrscheinlichkeit 0,5 im Zustand S1 zu bleiben. Diese Bitfehlerwahrscheinlichkeiten können jedoch auch in Vektorform dargestellt werden. Ebenso können die Übergangswahrscheinlichkeiten in einer Matrixform dargestellt werden. Die in FIG 1 eingetragenen Bitfehlerwahrscheinlichkeiten und Übergangswahrscheinlichkeiten sind für die nachfolgenden Berechnungsbeispiele gültig.

Bevor mit der Berechnung der Restfehlerwahrscheinlichkeit begonnen wird, muss zunächst ein Nullzustand 4 definiert werden. Der Nullzustand 4 weist dabei so viele Variationsmöglichkeiten auf, wie es Zustände für den Markov-modulierten Bernoulliprozess gibt. Für den in FIG 1 beispielhaft gezeigten Markov-modulierten Bernoulliprozess beträgt die Anzahl der verschiedenen Zustände drei. Somit weist der vorgegebenen Nullzustand 4 drei Zustände auf.

Da bei der Signalübertragung die Nachricht durch das lineare Schieberegister mit Rückkopplungen geschoben wird, bestimmt eine Länge S des linearen Schieberegisters mit Rückkopplungen deren Variationsmöglichkeiten. Die Länge S des linearen Schieberegisters mit Rückkopplungen ergibt sich aus dem höchsten Grad des verwendeten Generatorpolynoms. Das lineare Schieberegister mit Rückkopplungen stellt eine Implementierung einer Polynomdivision dar und ist derart konzipiert, dass bei einem Bitfehler an einer entsprechenden Stelle eine Eins erscheint. Tritt kein Übertragungsfehler auf, so zeigen alle Stellen des linearen Schieberegisters mit Rückkopplungen den Wert Null an. Dies ist der vorgegebene Nullzustand 4.

In diesem Beispiel weist das lineare Schieberegister mit Rückkopplungen fünf Stellen auf und verfügt somit über 2^5 also 32 Variationsmöglichkeiten. Dies ergibt sich daraus, weil jede Stelle des Schieberegisters mit einer Null oder einer Eins belegt werden kann. Ferner können diese Zustände des linearen Schieberegisters für jeden Zustand des Markov-modulierten Bernoulliprozesses auftreten. Daher beträgt die Gesamtzahl der von einer Steuereinheit 5 zu berücksichtigenden Zustände für die Berechnung der Restfehlerwahrscheinlichkeit in diesem Beispiel 32 × 3 = 96.

Die Steuereinheit 5 kann als Mikrochip, Mikroprozessor, speicherprogrammierbare Steuerung (SPS) oder als Computer ausgebildet sein. Sie ermittelt gemäß dem erfindungsgemäßen Verfahren die Restfehlerwahrscheinlichkeit bei einer Signalübertragung auf der Grundlage eines gewählten Kanalmodells.

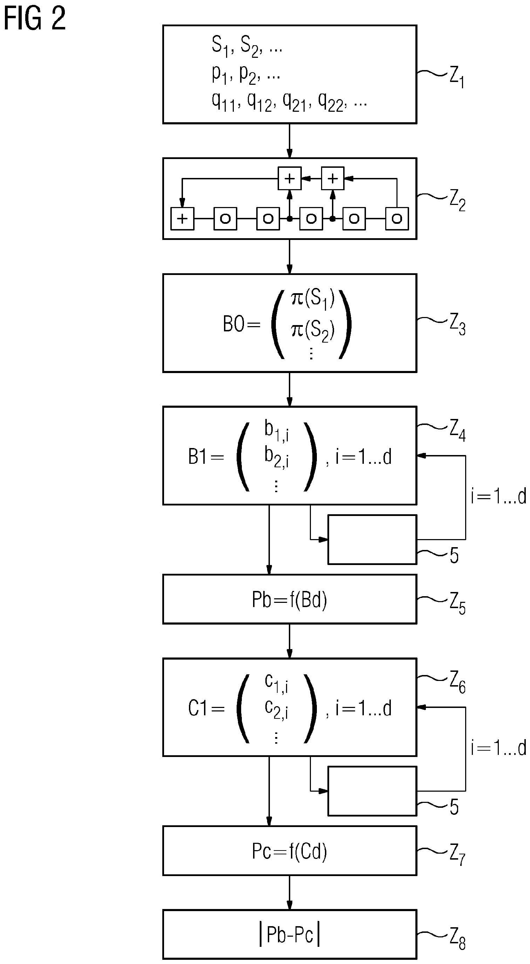

Die einzelnen Verfahrensschritte werden beispielhaft in einem Flussdiagramm in FIG 2 gezeigt. Zunächst wird im Schritt Z1 eine Ausgangslage festgelegt. Dazu zählen die in FIG 1 enthaltenen Informationen. Diese sind die Anzahl der verschiedenen Zustände S0, S1, S2, die Bitfehlerwahrscheinlichkeiten p1, p2, p3 sowie die entsprechenden Übergangswahrscheinlichkeiten q11, q12, usw. Im nächsten Schritt Z2 wird ein passendes lineares Schieberegister mit Rückkopplungen bestimmt. Die Länge S dieses linearen Schieberegisters mit Rückkopplungen ergibt sich durch den höchsten Polynomgrad des verwendeten Generatorpolynoms. In diesem Beispiel weist das lineare Schieberegister mit Rückkopplungen im Schritt Z2 fünf Stellen auf. Mithilfe des linearen Schieberegisters mit Rückkopplungen kann in Kombination mit den im Schritt Z2 eingezeichneten XOR Schaltungen eine Polynomdivision implementiert werden. Für die vorliegende Erfindung ist es jedoch nicht nötig, die Ausführung dieser Polynomdivision zu verstehen. Wichtig ist, dass mithilfe des linearen Schieberegisters mit Rückkopplungen sowie der Anzahl der Zustände des Markov-modulierten Bernoulliprozesses die Anzahl aller möglichen Zustände der jeweiligen Bits bei der Signalübertragung berechnet werden kann, welche die Steuereinheit 5 dann im Berechnungsverfahren für die Restfehlerwahrscheinlichkeit berücksichtigt.

Im Schritt Z3 wird eine stationäre Wahrscheinlichkeitsverteilung für diese 96 Zustände festgelegt. In diesem Beispiel ist B0 ein Vektor, der eine Spalte und 96 Zeilen aufweist. Die ersten drei Zeilen dieses Beispiels charakterisieren den vorgegebenen Nullzustand 4. Es gibt zwar nur einen Nullzustand 4 des linearen Schieberegisters, jedoch gibt es drei Zustände im Markov-modulierten Bernoulliprozess. Daher weist der Nullzustand 4 insgesamt drei Einträge auf. Darin werden während des Verfahrens Wahrscheinlichkeitswerte eingetragen. Diese ersten drei Zeilen, welche den Nullzustand 4 darstellen, beinhalten im Vektor B0 die vorgegebene stationäre Wahrscheinlichkeitsverteilung. Die Berechnung dieser stationären Wahrscheinlichkeitsverteilung erfolgt auf der Grundlage einer stochastischen Berechnung, welche jedoch nicht Teil dieser Erfindungsmeldung ist.

Für alle weiteren restlichen Zustände wird im Schritt Z3 der Wert Null eingetragen. Das heißt ab der vierten Zeile bis zur letzten Zeile beinhaltet der Vektor B0 keine Einträge beziehungsweise nur Nullen. Dieser Vektor B0, welcher als erste Spalte einer Tabelle aufgefasst werden kann, beschreibt, in welchem Zustand die Nachricht vor der Übertragung vorliegt. Da nicht davon ausgegangen wird, dass bereits vor der Übertragung der Nachricht ein Fehler vorliegt, also eine falsche Nachricht vorliegt, weist der Vektor B0 ab der vierten Zeile nur Nullen auf.

Im Schritt Z4 beginnt das erste iterative Berechnen. Ausgehend von der stationären Wahrscheinlichkeitsverteilung im Vektor B0 ermittelt die Steuereinheit 5 alle möglichen Übergänge und berechnet deren Wahrscheinlichkeiten gemäß dem erfindungsgemäßen Verfahren. Die dazu nötigen Bitfehlerwahrscheinlichkeiten und Übergangswahrscheinlichkeiten sind durch den Markov-modulierten Bernoulliprozess gemäß FIG 1 vorgegeben. Durch diese iterative Berechnung im Schritt Z4 werden neue Vektoren beziehungsweise Spalten Bi erzeugt, welche Wahrscheinlichkeitswerte für die möglichen Zustände der Signalübertragung angeben.

Jede Spalte gibt dabei an, wie die Wahrscheinlichkeitsverteilung bis zu dem jeweiligen Bit vorliegt. Betrachtet man beispielsweise eine siebte Spalte, so geben die Wahrscheinlichkeitswerte an, wie die Nachricht übertragen worden wäre, wenn die Nachricht sieben Bit lang wäre. Die Spaltensumme ist dabei bis auf etwaige Rundungsfehler stets eins.

Dabei addiert die Steuereinheit 5 die Wahrscheinlichkeitswerte unterschiedlicher Übergänge, die in einem gleichen Zustand enden. Diese iterative Berechnung wird bis zum Vektor Bd beziehungsweise bis zur Spalte Bd ausgeführt. Die letzte Spalte dieses iterativen Berechnungsverfahrens im Schritt Z4 beinhaltet eine Wahrscheinlichkeitsverteilung Pb für die übertragene Nachricht im Nullzustand 4. Diese Wahrscheinlichkeitswerte werden im Schritt Z5 temporär zwischengespeichert.

Im Schritt Z6 wird eine ähnliche iterative Berechnung wie im Schritt Z4 ausgeführt. Bei diesem zweiten iterativen Berechnungsverfahren berücksichtigt die Steuereinheit 5 jedoch nur jene Übergänge, welche im vorgegebenen Nullzustand 4 starten und nicht aus diesem Nullzustand 4 heraus führen.

Damit berechnet die Steuereinheit 5 in jedem Schritt eine in der Regel verschiedene Wahrscheinlichkeitsverteilung wie im Schritt Z4. Da die Nachricht d Bits lang ist, werden wie bei der ersten Iteration ebenfalls d Vektoren von Ci berechnet (C1, C2, ..., Cd). Von Bedeutung für den nächsten Schritt zur Berechnung der Restfehlerwahrscheinlichkeit sind die jeweils letzten Vektoren Bd und Cd. Von diesen Vektoren sind wiederum nur die ersten drei Einträge interessant, da diese den Nullzustand 4 charakterisieren. Diese drei Zeilen beinhalten die Wahrscheinlichkeitswerte für eine vom linearen Schieberegister mit Rückkopplungen korrekt angezeigte Übertragung. Beim Vektor Bd sind jedoch auch jene Übertragungen aus fehlerhaften Zuständen in den Nullzustand 4 zurück enthalten. Genau diese Übergänge gilt es als Restfehlerwahrscheinlichkeit zu quantifizieren.

In einem Schritt Z7 extrahiert die Steuereinheit 5 die Wahrscheinlichkeitswerte des vorgegebenen Nullzustands 4 im letzten berechneten Vektor beziehungsweise der letzten berechneten Spalte von beiden iterativen Berechnungsverfahren (Z4, Z6).

Da jedoch bei der iterativen Berechnung im Schritt Z6 die Steuereinheit 5 nicht alle Übergänge berücksichtigt hat, ist die berechnete Wahrscheinlichkeitsverteilung Pc im Schritt Z7 von jener Pb im Schritt Z5 unterschiedlich. Im Schritt Z8 wird die Restfehlerwahrscheinlichkeit durch Bildung der Differenz der Wahrscheinlichkeitswerte im Schritt Z7 von denen im Schritt Z5 gebildet. Die Steuereinheit 5 kann dazu zum Beispiel folgende die Rechenoperation Bd-Cd ausführen, wobei nur die ersten drei Einträge berücksichtigt werden.

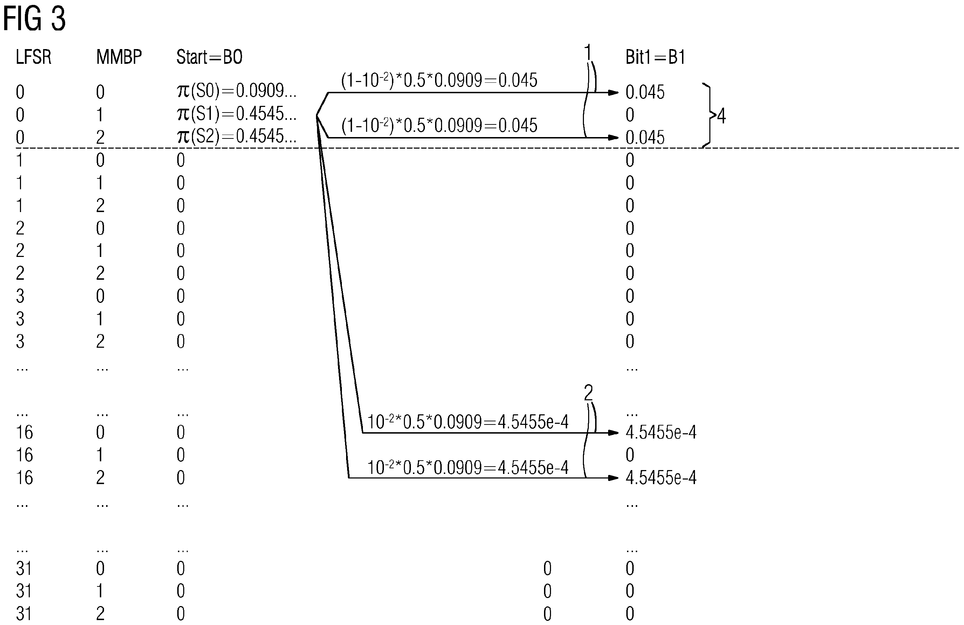

Um die Berechnung der Restfehlerwahrscheinlichkeit besser zu veranschaulichen, wird in FIG 3 beispielhaft eine Tabelle mit Übergängen aus dem Zustand S0 heraus gezeigt. Die ersten beiden Spalten LFSR sowie MMBP sind für die Berechnung der Restfehlerwahrscheinlichkeit nicht zwingend nötig, jedoch veranschaulichen diese beiden Spalten die Anzahl aller möglichen Zustände bei der Signalübertragung. In diesem Beispiel hat das lineare Schieberegister mit Rückkopplungen die Länge S von fünf Bits, daher existieren 32 Variationsmöglichkeiten innerhalb des linearen Schieberegisters mit Rückkopplungen. Da ein Bit jeweils nur die Zustände Null beziehungsweise Eins annehmen kann, gibt es für jede Stelle im linearen Schieberegister mit Rückkopplungen zwei Möglichkeiten. Weist das lineare Schieberegister mit Rückkopplungen fünf Stellen auf, so ergeben sich entsprechend 2^S=32 Möglichkeiten.

Da in diesem Beispiel die Zählung dieser 32 Möglichkeiten bei null beginnt, lauten die letzten Einträge der ersten Spalte (LFSR) 31. Da der Markov-modulierte Bernoulliprozess gemäß FIG 1 drei Zustände (S0, S1 und S2) aufweist, besitzt jeder Zustand des linearen Schieberegisters mit Rückkopplungen drei Zustände. Damit ergeben sich insgesamt 2^5 × 3 = 96 Variationsmöglichkeiten für die Signalübertragung, welche die Steuereinheit 5 berücksichtigt.

Zunächst wird zur Initialisierung eine stationäre Wahrscheinlichkeitsverteilung in der dritten Spalte der FIG 3 eingetragen. Diese Spalte, welche mit B0 gekennzeichnet ist, entspricht dem Schritt Z3 aus FIG 2. Diese Spalte weist ab der vierten Zeile nur Nullen auf. Dies liegt daran, dass nicht von einem Fehler bereits bei der Initialisierung ausgegangen wird. Die ersten drei Zeilen der Tabelle in FIG 3 repräsentieren den vorgegebenen Nullzustand 4. In diesen vorgegebenen Nullzustand 4 weist das lineare Schieberegister mit Rückkopplungen nur Einträge mit Nullen auf. Bei einem Übertragungsfehler erscheint im linearen Schieberegister mit Rückkopplungen anstatt einer Null eine Eins. Der Nullzustand 4 zeigt also eine vermeintlich korrekt übertragende Nachricht an. Alle weiteren Zustände kennzeichnen einen Fehler bei der Signalübertragung. Dabei werden diese Fehler allerdings als solche erkannt, da das lineare Schieberegister mit Rückkopplungen vom Nullzustand 4 abweicht.

Gemäß der stationären Wahrscheinlichkeitsverteilung liegt der Zustand S0 mit einer Wahrscheinlichkeit von etwa 0,09 vor. Gemäß den Eigenschaften des Markov-modulierten Bernoulliprozesses können die Wahrscheinlichkeitswerte für eine korrekte Übertragung 1 abgelesen werden. Gemäß FIG 1 sind in diesem Beispiel vom Zustand S0 zwei Übergänge mit einer Wahrscheinlichkeit von je 0,5 vorgesehen. Da die Wahrscheinlichkeitswerte für die korrekten Übertragungen 1 ermittelt werden, wird nicht die Bitfehlerwahrscheinlichkeit, sondern die entsprechende Gegenwahrscheinlichkeit verwendet. Daher berechnet sich in diesem Beispiel die Wahrscheinlichkeit, dass das Bit 1 vom Zustand S0 in den Zustand S2 im Nullzustand 4 übertragen wird mit (1-10^(-2))^{∗}0,5^{∗}0,0909 zu etwa 0,045.

Neben den Wahrscheinlichkeitswerten für die korrekten Übertragungen 1 gibt es auch Wahrscheinlichkeitswerte für fehlerhafte Übertragungen 2. Diese Wahrscheinlichkeitswerte berechnen sich analog wie bei der korrekten Übertragung 1 mit dem Unterschied, dass die jeweilige Bitfehlerwahrscheinlichkeit pi und nicht das Gegenereignis zur Berechnung herangezogen wird. Da der Zustand S0 eine Bitfehlerwahrscheinlichkeit von 10^-(2) aufweist, ergeben sich für die beispielhaften fehlerhaften Übertragungen 2 entsprechend reduzierte Wahrscheinlichkeitswerte (10^(-2)^{∗}0,5^{∗}0,0909).

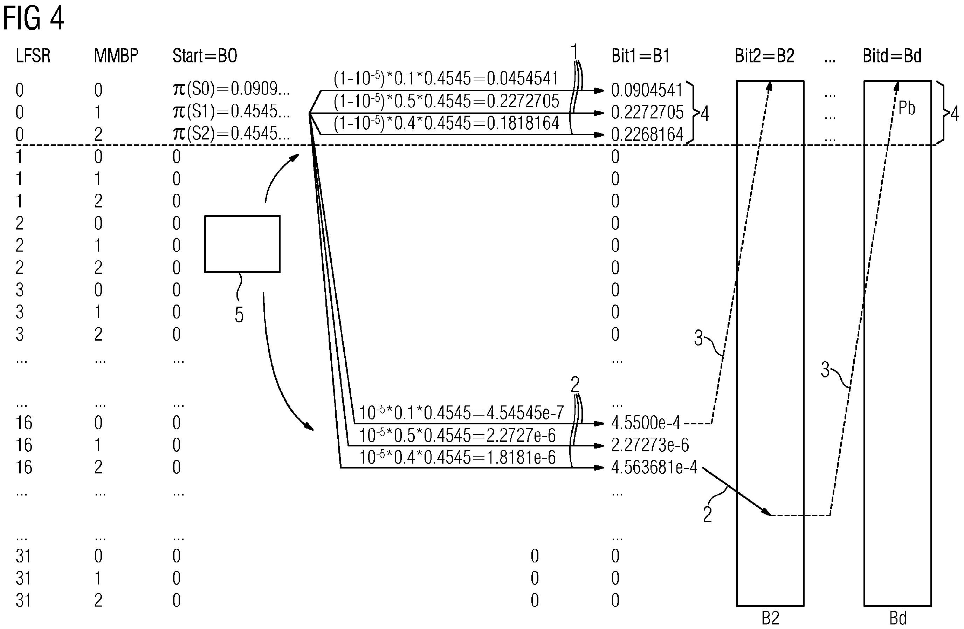

In FIG 4 ist beispielhaft eine Tabelle gezeigt, wie das Verfahren im weiteren Verlauf von der Steuereinheit 5 fortgeführt wird. Aus dem Zustand S1 sind insgesamt sechs Übergänge möglich. Jeweils drei Übergänge ergeben sich für die korrekten Übertragungen 1 innerhalb des Nullzustands 4, weitere drei Übergänge ergeben sich für die fehlerhaften Übertragungen 2, die aus dem Nullzustand 4 herausführen. Die Berechnung der in FIG 4 beispielhaft gezeigten Wahrscheinlichkeitswerte erfolgt analog wie in FIG 3. Die FIG 4 zeigt beispielhaft, dass für den Übergang aus dem Zustand S1 für die stationäre Verteilung (Spalte B0) in den Zustand S0 des Bit 1 die Wahrscheinlichkeit 0,045 beträgt. Da in der Spalte B1 der Zustand S0 durch verschiedene Übergänge erreichbar ist, ergeben sich mehrere Wahrscheinlichkeiten, dass der Zustand S0 bei Bit 1 erreicht wird. Diese Wahrscheinlichkeitswerte der verschiedenen Übergänge in den Zustand S0 vom Bit 1 addiert die Steuereinheit 5 zusammen.

Dieses Verfahren wird von der Steuereinheit 5 nun sukzessive fortgeführt, bis die Wahrscheinlichkeitswerte aller möglichen Übergänge bis zur letzten Spalte berücksichtigt worden sind. Da in diesem Fall die Spalte B0 viele Nullen aufweist, endet die iterative Berechnung für diese Spalte bereits nach Abschluss der dritten Zeile. In FIG 3 und FIG 4 ist nur beispielhaft ein Ausschnitt der Berechnung durch die Steuereinheit 5 gezeigt.

Ist die Berechnung der Wahrscheinlichkeitswerte für die Spalte B1 ausgeführt, so werden mit demselben Berechnungsverfahren die Wahrscheinlichkeitswerte für die nächste Spalte, welche das Bit 2 beziehungsweise die Spalte / den Vektor B2 repräsentiert durchgeführt. Die Werte für die Übergangswahrscheinlichkeiten und die Bitfehlerwahrscheinlichkeiten ergeben sich aus dem charakterisierenden Markov-modulierten Bernoulliprozess gemäß FIG 1. In FIG 4 sind beispielhaft zwei weitere Spalten B2 und Bd angedeutet mit Übergängen aus dem Zustand LFSR 16 und MMBP 0 zurück in den Nullzustand 4. Dieser Pfad stellt eine fehlerhafte unerkannte Signalübertragung 3 dar, weil sie zurück in den Nullzustand 4 führt, der die korrekte Übertragung 1 signalisiert.

Bei der ersten iterativen Berechnung werden diese Übergänge von fehlerhaften unerkannten Signalübertragungen 3 berücksichtigt. Diese Pfade der Signalübertragung erhöhen die Wahrscheinlichkeitswerte des Nullzustands 4. Die Wahrscheinlichkeitswerte für den Nullzustand 4 beinhalten somit auch die Fälle von fehlerhaften unerkannten Signalübertragungen 3. Es handelt sich hierbei um einen Fehler in der Signalübertragung, der nicht erkannt wird. Alle Wahrscheinlichkeitswerte außerhalb des Nullzustands 4 repräsentieren ebenfalls Fehler bei der Signalübertragung. Jedoch können diese Fehler erkannt werden, da das lineare Schieberegister mit Rückkopplungen wenigstens eine Eins aufweist, was einen Fehler bei der Signalübertragung andeutet.

Wird ausgehend vom stationären Zustand S1 das Bit 1 fehlerhaft übertragen und findet ausgehend von diesem fehlerhaften Zustand eine Übertragung zurück in den Nullzustand 4 statt, so ist bei der Signalübertragung ein Fehler aufgetreten, der nicht erkannt wurde und zu einer Erhöhung der Wahrscheinlichkeitswerte im Nullzustand 4 führt. Die Wahrscheinlichkeitswerte des Nullzustands 4 beinhalten somit die Restfehlerwahrscheinlichkeit. Um diese daraus zu extrahieren, führt die Steuereinheit 5 im weiteren Verlauf die zweite iterative Berechnung durch.

Die Steuereinheit 5 führt nun diese zweite iterative Berechnung bis zur Spalte Bd, welche die übertragende Nachricht repräsentiert, durch. Jedoch werden bei der zweiten iterativen Berechnung alle Übergänge, welche vom Nullzustand 4 herausführen, vernachlässigt. Damit ergeben sich in der Regel im Verlauf der in der zweiten durchgeführten iterativen Berechnung andere Wahrscheinlichkeitswerte für den Nullzustand 4. Diese zweite iterative Berechnung führt die Steuereinheit 5 bis zur letzten Spalte Bd aus. Damit ergeben sich in der letzten Spalte Bd die Wahrscheinlichkeitswerte Pc für die Zustände der übertragenen Nachricht im Nullzustand 4 ohne die fehlerhaften unerkannten Signalübertragungen.

In den Wahrscheinlichkeitswerten Pb der letzten Spalte Bd des Nullzustands 4 sind auch jene Wahrscheinlichkeitswerte der fehlerhaften unerkannten Signalübertragung 3 enthalten. Die Wahrscheinlichkeitswerte Pb wurden in der ersten iterativen Berechnung durchgeführt und dabei wurden alle möglichen Übergänge berücksichtigt. Um die Wahrscheinlichkeitswerte für diese fehlerhaften unerkannten Signalübertragungen 3 zu extrahieren, bildet die Steuereinheit 5 die Differenz der Wahrscheinlichkeitsverteilungen Pb und Pc, wobei nur die Einträge für den Nullzustand beachtet werden.

In diesem Beispiel ergeben sich für die Signalübertragung drei Wahrscheinlichkeitswerte für Pb aus der ersten iterativen Berechnung und weitere drei Wahrscheinlichkeitswerte für Pc aus der zweiten iterativen Berechnung. Nun bildet die Steuereinheit die Differenz Pb-Pc, was die Restfehlerwahrscheinlichkeit ergibt. Mit anderen Worten wird die Differenz der Vektoren Bd und Cd gebildet, wobei in diesem Fall nur die ersten drei Zeilen berücksichtigt werden.

Das in FIG 3 und in FIG 4 gezeigte beispielhafte Verfahren kann jedoch auch anders ausgeführt werden. Anstelle einer zweiten iterativen Berechnung kann eine zusätzliche Variable eingeführt werden, welche die Wahrscheinlichkeitswerte von Übergängen, die im Nullzustand 4 beginnen und in ihm verbleiben, zwischenspeichert.

Je nach vorgegebenen Markov-modulierten Bernoulliprozess kann die Steuereinheit 5 die Restfehlerwahrscheinlichkeit für unterschiedliche Generatorpolynome berechnen. Dabei kann vorgesehen sein, dass aus einer Vielzahl von unterschiedlichen Generatorpolynomen dasjenige ausgewählt wird, welches die geringste Restfehlerwahrscheinlichkeit aufweist. Das Auswählen unterschiedlicher Generatorpolynome kann in regelmäßigen oder auch unregelmäßigen Zeitabständen ausgeführt werden.

Dieses automatische Auswählen wird nun beispielhaft an einem Kraftfahrzeug mit Klimaanlage erläutert. Moderne Kraftfahrzeuge weisen in der Regel eine Klimaanlage auf sowie dazugehörige Temperatursensoren. Das Kraftfahrzeug soll in diesem Beispiel einen Temperatursensor für die Außentemperatur und einen weiteren Temperatursensor für die Innentemperatur aufweisen. Diese so gemessenen Temperaturwerte werden durch die Steuereinheit 5 zur Klimaanlage übertragen. Anhand der übertragenen Temperaturwerte erhöht oder senkt die Klimaanlage ihre Kühlleistung.

Ist das Kraftfahrzeug beispielsweise in Mitteleuropa bei gemäßigten Temperaturen im Einsatz, so kann dafür ein bestimmtes Kanalmodell für die Signalübertragung vorgesehen sein. Nun soll dasselbe Kraftfahrzeug in einer heißen Umgebung, beispielsweise in der Wüste, eingesetzt werden. Damit ändern sich die Umgebungsbedingungen. Vermutlich werden sich die Bitfehlerwahrscheinlichkeiten erhöhen und auch die Wahrscheinlichkeitswerte für die Übergangsmatrix können sich durch den Standortwechsels des Kraftfahrzeugs verändern. Mit anderen Worten der in FIG 1 gezeigte beispielhafte Markov-modulierte Bernoulliprozess ändert sich.

Nun kann mit dem erfindungsgemäßen Verfahren in der neuen Umgebung die Restfehlerwahrscheinlichkeit anderer Generatorpolynome berechnet werden. Dabei kann sich ergeben, dass ein anderes Generatorpolynom als jenes, welches für die Region Mitteleuropa eingesetzt wurde, für die Signalübertragung in der Wüste besser geeignet ist.

Ferner kann das erfindungsgemäße Verfahren in einen intelligenten Regelkreis eingebunden werden, welcher die Restfehlerwahrscheinlichkeit bei Änderungen der Umgebungsparameter neu berechnen kann und auf Grundlage der so berechneten Restfehlerwahrscheinlichkeiten automatisiert ein besseres Generatorpolynom auswählt. Dabei kann insbesondere auch vorgesehen sein, dass der so beschriebene Regelkreis eigenständig die Auswahl eines geeigneten Generatorpolynoms lernt und stetig verbessert.

Ein solcher dynamischer Regelkreis kann verschiedene Komponenten umfassen. Eine Analysekomponente kann vorgesehen sein, welche die Häufigkeit und Verteilung von Bitfehlern bestimmt. Dies kann zum Beispiel durch das regelmäßige Senden einer bekannten Nachricht geschehen.

Ein Bernoulli-Generator könnte einen passenden Markov-modulierten Bernoulliprozess parametrisieren, also mit Zuständen, Übergängen und Wahrscheinlichkeitswerten ausstatten. Dies entspricht dem "Lernproblem" aus dem Bereich "Hidden Markov Models". Gängige Algorithmen zur Lösung dieses Problems sind der Baum-Welch-Algorithmus und der Baldi-Chauvin-Algorithmus. Der Rechenaufwand dafür ist gering, da der Markov-modulierte Bernoulliprozess nur über wenige Zustände verfügt. Beim Gilbert-Elliot-Modell sind es zum Beispiel nur zwei Zustände.

Die Steuereinheit 5 kann nun die Restfehlerwahrscheinlichkeiten aller in Frage kommenden Codes gemäß dem erfindungsgemäßen Verfahren berechnen. Diese Codes können sich beispielsweise in den Generatorpolynomen oder in den Codewortlängen unterscheiden.

Eine Auswahlkomponente kann zur Auswahl eines Generatorpolynoms eingesetzt werden. Diese Auswahlkomponente sollte sich mit den Kommunikationspartnern, beispielsweise mit dem Sender und Empfänger, abstimmen, um einen gleichzeitigen Wechsel des verwendeten Codes zu erreichen. Mit der Analysekomponente, dem Bernoulli-Generator, der Steuereinheit 5 sowie der Auswahlkomponente kann ein dynamisches System geschaffen werden, welches je nach Bedarf das beste verfügbare Generatorpolynom auswählt. In der Regel wird dies jenes Generatorpolynom mit der geringsten Restfehlerwahrscheinlichkeit sein.

Im Beispiel des Kraftfahrzeugs mit Klimaanlage können Änderungen der Umgebungsparameter nicht nur durch einen Standortwechsel hervorgerufen werden, sondern beispielsweise auch wenn die Klimaanlage in verschiedenen Kraftfahrzeugtypen eingebaut wird. So kann beispielsweise dieselbe Klimaanlage in einem Audi einen anderen Markov-modulierten Bernoulliprozess aufweisen als bei derselben Klimaanlage, welche beispielsweise in einem Porsche verbaut ist. Im Porsche können andere Kabel für die Signalübertragung vorhanden sein, eine Batterie könnte Störfelder generieren, was die Signalübertragung beeinflusst. Dies sind einige Beispiele, warum bei derselben Klimaanlage in unterschiedlichen Fahrzeugen verschiedene Generatorpolynome anzuwenden sind.

Die Restfehlerwahrscheinlichkeit ist ein wichtiges Kriterium für eine zuverlässige Signalübertragung und diese wurde bisher nur anhand des starren BSC-Modells ermittelt. Mit dem erfindungsgemäßen Verfahren, was mit einem intelligenten dynamischen Regelkreis kombinierbar ist, können aus einer Auswahl von verschiedenen Generatorpolynomen jene Generatorpolynome für die Signalübertragung von der Steuereinheit 5 bestimmt werden, die eine möglichst geringe Restfehlerwahrscheinlichkeit aufweisen.

## Patentansprüche

1. Verfahren zur Überprüfung einer Signalübertragung einer vorgegebenen Nachricht mit einer Anzahl von d Bits von einem Sender zu einem Empfänger durch eine Steuereinheit (5) unter Verwendung eines linearen Blockcodes, der mittels eines Codier-Werkzeugs realisiert wird, eines Kanalmodells und eines lineares Schieberegisters mit Rückkopplungen mit den folgenden Schritten:
- Beschreiben des Kanalmodells durch einen charakterisierenden Markov-modulierten Bernoulliprozess,
- Iteratives erstes Berechnen von Wahrscheinlichkeitswerten für eine Wahrscheinlichkeitsverteilung von Zuständen eines bezogen auf ein aktuelles Bit der d Bits nach der Signalübertragung durch eine Signalübertragungseinheit ausgehend von der aktuellen Wahrscheinlichkeitsverteilung der Zustände des aktuellen Bits unter Berücksichtigung aller möglichen Übergänge, welche sich aus dem kartesischen Produkt der Anzahl der Zustände gemäß dem vorgegebenen Markov-modulierten Bernoulliprozess und der Anzahl der Zustände des linearen Schieberegisters mit Rückkopplungen ergeben, wobei die Steuereinheit (5) die Wahrscheinlichkeitswerte von Übergängen in einen gleichen Zustand addiert und diese Iteration bis zur Wahrscheinlichkeitsverteilung des letzten Bits ausführt,
- Iteratives zweites Berechnen von Wahrscheinlichkeitswerten für die Wahrscheinlichkeitsverteilung der Zustände eines bezogen auf ein aktuelles Bit der d Bits nach der Signalübertragung durch die Signalübertragungseinheit ausgehend von der aktuellen Verteilung der Zustände des aktuellen Bits unter Vernachlässigung aller Übergänge aus einem vorgegebenen Nullzustand (4) heraus, wobei die Steuereinheit (5) die Wahrscheinlichkeitswerte von Übergängen in einen gleichen Zustand addiert und diese Iteration bis zur Wahrscheinlichkeitsverteilung des letzten Bits ausführt,
- Bilden einer Differenz von den Wahrscheinlichkeitswerten des vorgegebenen Nullzustands (4) aus der ersten iterativen Berechnung mit den Wahrscheinlichkeitswerten des vorgegebenen Nullzustands (4) aus der zweiten iterativen Berechnung als eine Restfehlerwahrscheinlichkeit.

2. Verfahren nach Anspruch 1, wobei die iterative zweite Berechnung der Wahrscheinlichkeitswerte für die Wahrscheinlichkeitsverteilung der Zustände des letzten Bits unter Vernachlässigung aller Übergänge aus dem vorgegebenen Nullzustand (4) heraus zusammen mit der ersten iterativen Berechnung erfolgt unter Verwendung lokaler Speicherstellen, die die Ergebnisse der iterativen Berechnung zumindest bis zur Berechnung der Restfehlerwahrscheinlichkeit zwischenspeichern.

3. Verfahren nach einem der vorigen Ansprüche, wobei das lineare Schieberegister mit Rückkopplungen, welches mittels eines Generatorpolynoms parametrisiert ist, als Codier-Werkzeug eingesetzt wird.

4. Verfahren nach einem der vorigen Ansprüche, wobei zu Beginn des Verfahrens eine Tabelle mit d+1 Spalten generiert wird, welche mit Nullen allokiert wird, wobei in den Spalten die jeweiligen Wahrscheinlichkeitswerte eingetragen werden.

5. Verfahren nach einem der Ansprüche 3 bis 4, wobei bei dem vorgegebenen Kanalmodell unterschiedliche Generatorpolynome zur Berechnung der Restfehlerwahrscheinlichkeit eingesetzt werden.

6. Verfahren nach einem der vorigen Ansprüche, wobei für unterschiedliche Kanalmodelle mit jeweiligen Markov-modulierten Bernoulliprozess die jeweilige Restfehlerwahrscheinlichkeit berechnet wird.

7. Verfahren nach einem der Ansprüche 4 bis 6, wobei die Steuereinheit (5) zur Berechnung der Restfehlerwahrscheinlichkeit nur jeweils zwei Spalten der Tabelle gleichzeitig im Speicher hält.

8. Verfahren nach Anspruch 3 bis 7, wobei das Generatorpolynom durch einen Regelkreis anhand der Restfehlerwahrscheinlichkeiten ausgewählt wird.

9. Verfahren nach dem Anspruch 8, wobei das Auswählen des jeweiligen Generatorpolynoms gelernt wird.

10. Verfahren nach einem der vorigen Ansprüche, wobei zur Initialisierung des iterativen Berechnens eine stationäre Verteilung der Wahrscheinlichkeitswerte für den vorgegebenen Nullzustand (4) berechnet wird.

11. Vorrichtung zur Überprüfung einer Signalübertragung einer vorgegebenen Nachricht mit d Bits von einem Sender zu einem Empfänger durch eine Steuereinheit (5), die ausgebildet ist zur Durchführung eines Verfahrens gemäß einem der vorigen Ansprüche.

## Claims

1. Method for checking a signal transmission of a specified message with a number of d bits from a sender to a receiver by a control unit (5) using a linear block code, which code is created using a coding tool, a channel model, and a linear feedback shift register, with the following steps:
- description of the channel model by a characterising Markov-modulated Bernoulli process,
- iterative first calculation of probability values for a probability distribution of states of one of the d bits relative to a current bit after signal transmission by a signal transmission unit, starting from the current probability distribution of the states in the current bit, taking into account all the possible transitions that result from the Cartesian product of the number of states according to the specified Markov-modulated Bernoulli process and the number of states of the linear feedback shift register, wherein the control unit (5) adds the probability values of transitions into an equal state and carries out this iteration up to the probability distribution of the final bit,
- iterative second calculation of probability values for the probability distribution of the states of one of the d bits relative to a current bit after signal transmission by the signal transmission unit, starting from the current probability distribution of the states in the current bit, ignoring all the transitions out of a specified zero state (4), wherein the control unit (5) adds the probability values of transitions into an equal state and carries out this iteration up to the probability distribution of the final bit,
- forming a difference from the probability values of the specified zero state (4) out of the first iterative calculation with the probability values of the specified zero state (4) out of the second iterative calculation, as a residual error probability.

2. Method according to claim 1, wherein the iterative second calculation of the probability values for the probability distribution of the states of the final bit, ignoring all the transitions out of the specified zero state (4), ensues together with the first iterative calculation, using local memory locations, which cache the results of the iterative calculation at least up to the calculation of the residual error probability.

3. Method according to one of the preceding claims, wherein the linear feedback shift register, which is parameterised by means of a generator polynomial, is used as a coding tool.

4. Method according to one of the preceding claims, wherein a table with d+1 columns is generated at the start of the method, which table is allocated zeros, wherein the respective probability values are recorded in the columns.

5. Method according to one of claims 3 to 4, wherein different generator polynomials are used in the specified channel model to calculate the residual error probability.

6. Method according to one of the preceding claims, wherein the respective residual error probability is calculated for different channel models with a respective Markov-modulated Bernoulli process.

7. Method according to one of claims 4 to 6, wherein the control unit (5) in each case holds in the memory only two columns of the table to calculate the residual error probability.

8. Method according to claim 3 to 7, wherein the generator polynomial is selected by a control circuit on the basis of the residual error probabilities.

9. Method according to claim 8, wherein the selection of the respective generator polynomial is learnt.

10. Method according to one of the preceding claims, wherein a stationary distribution of the probability values for the specified zero state (4) is calculated for the initialisation of the iterative calculation.

11. Apparatus for checking a signal transmission of a specified message with d bits from a sender to a receiver by a control unit (5), which is embodied to carry out a method according to one of the preceding claims.

## Revendications

1. Procédé de contrôle d'une transmission de signal d'un message donné à l'avance, ayant un nombre d de bits d'un émetteur à un récepteur par une unité (5) de commande, en utilisant un code complet linéaire, réalisé au moyen d'un outil de codage, d'un modèle de canal et d'un registre à décalage linéaire à réactions, comprenant les stades :
- description du modèle de canal par un processus de Bernoulli à modulation de Markov caractérisant,
- premier calcul itératif de valeurs de probabilité d'une distribution de probabilité d'états de l'un, rapporté à un bit présent, des d bits, après la transmission du signal par une unité de transmission du signal, à partir de la distribution de probabilité présente des états du bit présent, en tenant compte de toutes les transitions possibles, qui proviennent du produit cartésien du nombre des états suivant le processus de Bernoulli à modulation de Markof donné à l'avance et du nombre des états du registre à décalage linéaire à réactions, l'unité (5) de commande additionnant les valeurs de probabilité de transition dans un même état et effectuant cette itération jusqu'à la distribution de probabilité du dernier bit,
- deuxième calcul itératif de valeurs de probabilité de la distribution de probabilité des états de l'un, rapporté à un bit présent, des d bits, après la transmission du signal par une unité de transmission du signal, à partir de la distribution présente des états du bit présent, en négligeant toutes les transitions à partir d'un état (4) zéro donné à l'avance, l'unité (5) de commande additionnant les valeurs de probabilité de transition dans un même état et exécutant cette itération jusqu'à la distribution de probabilité du dernier bit,
- formation d'une différence des valeurs de probabilité de l'état (4) zéro donné à l'avance, à partir du premier calcul itératif, aux valeurs de probabilité de l'état (4) zéro donné à l'avance, à partir du deuxième calcul itératif, comme probabilité d'erreur résiduelle.

2. Procédé suivant la revendication 1, dans lequel le deuxième calcul itératif des valeurs de probabilité de la distribution de probabilité des états du dernier bit s'effectue en négligeant toutes les transitions à partir de l'état (4) zéro donné à l'avance, ensemble avec le premier calcul itératif, en utilisant des points locaux de mémoire, qui mettent en mémoire tampon les résultats du calcul itératif, au moins jusqu'au calcul de la probabilité d'erreur résiduelle.

3. Procédé suivant l'une des revendications précédentes, dans lequel on utilise, comme outil de codage, le registre à décalage linéaire à réactions, qui est paramétré au moyen d'un polynôme générateur.

4. Procédé suivant l'une des revendications précédentes, dans lequel, au début du procédé, on produit une table ayant d+1 colonnes, qui est affectée de zéros, les valeurs de probabilité respectives étant portées dans les colonnes.

5. Procédé suivant l'une des revendications 3 à 4, dans lequel on utilise, dans le modèle de canal donné à l'avance, des polynômes générateurs différents pour calculer la probabilité d'erreur résiduelle.

6. Procédé suivant l'une des revendications précédentes, dans lequel on calcule la probabilité d'erreur résiduelle respective pour des modèles de canal différents par des processus de Bernoulli à modulation de Markov respectifs.

7. Procédé suivant l'une des revendications 4 à 6, dans lequel l'unité (5) de commande conserve en même temps en mémoire seulement respectivement deux colonnes de la table pour calculer la probabilité d'erreur résiduelle.

8. Procédé suivant l'une des revendications 3 à 7, dans lequel on choisit le polynôme générateur par un circuit de réglage, à l'aide des probabilités d'erreur résiduelles.

9. Procédé suivant la revendication 8, dans lequel on fait l'apprentissage du choix du polynôme générateur respectif.

10. Procédé suivant l'une des revendications précédentes, dans lequel, pour faire débuter le calcul itératif, on calcule une distribution stationnaire des valeurs de probabilité pour l'état (4) zéro donné à l'avance.

11. Système de contrôle d'une transmission de signal d'un état donné à l'avance ayant d bits d'un émetteur à un récepteur par une unité (5) de commande, qui est constitué pour effectuer un procédé suivant l'une des revendications précédentes.
